# EUROPEAN PATENT SPECIFICATION

(11) **EP 3 057 145 B1**
(45) Date of publication and mention of the grant of the patent: **10.06.2020**
(21) Application number: 15182529.6
(22) Date of filing: 26.08.2015
(51) Int. Cl.: H01L 33/50

(54) **SEMICONDUCTOR LIGHT EMITTING DEVICE AND METHOD FOR FORMING PHOSPHOR LAYER**
LICHTEMITTIERENDES HALBLEITERBAUELEMENT UND VERFAHREN ZUR HERSTELLUNG EINER PHOSPHORSCHICHT
DISPOSITIF ÉLECTROLUMINESCENT À SEMI-CONDUCTEUR ET PROCÉDÉ DE FORMATION D'UNE COUCHE DE PHOSPHORE

(30) Priority: 10.02.2015 JP 2015024066
(43) Date of publication of application: 17.08.2016
(73) Proprietor: ALPAD Corporation, Tokyo 100-6208 (JP)
(72) Inventor: Furuyama, Hideto, Tokyo (JP); Endo, Mitsuyoshi, Tokyo (JP); Shimojuku, Miyuki, Tokyo (JP); Itonaga, Shuji, Tokyo (JP); Nomura, Yukihiro, Tokyo (JP)
(74) Representative: Hoffmann Eitle

(56) References cited:
- EP-A1- 1 605 028
- EP-A1- 2 752 897
- US-A1- 2013 037 844

## Description

### FIELD

Embodiments described herein relate generally to a semiconductor light emitting device and a method for forming a phosphor layer.

### BACKGROUND

In recent years, a semiconductor light emitting device realizing a white light source with a light emitting element of nitride semiconductor and a phosphor layer is widely used. In such a semiconductor light emitting device, particularly in the high-power type, there has been an increasing demand for countermeasures against heat generation not only in the light emitting element but also in the phosphor layer.

US 2013/037844 A1 relates to a light-emitting device that is provided with a metal part atop a planar LED substrate, an LED element being disposed atop the metal part. A glass substrate is provided to an upper surface of the LED element, and a wavelength conversion part is formed on an upper surface of the glass substrate. The wavelength conversion part comprises a light-transmissive ceramic layer formed by heating a mixture containing a phosphor, an organometallic compound, a layered silicate mineral, an inorganic particulate, an organic solvent, and water.

EP 1 605 028 A1 relates to a long-life phosphor which is prevented from darkening due to aging. It also relates to a light emitting apparatus having a light emitting element and a phosphor layer. The phosphor layer has a phosphor excited by light from the light emitting element, and a binder which binds the phosphor. The binder is hydroxide oxide gel obtained by curing sol of a hydroxide oxide mixed with sol containing at least one metallic element selected from the group consisting of Al, Y, Gd, Lu, Sc, Ga, In, and B. Transmittance of hydroxide oxide in a gel state is higher than the transmittance in the polycrystal state where the sol-gel reaction is proceeded. In addition, the content of hydroxyl group or water of crystallization in the hydroxide oxide is 10% or less by weight.

### BRIEF DESCRIPTION OF THE DRAWINGS

FIG. 1 is an enlarged schematic sectional view of part of a phosphor layer of an embodiment;
FIG. 2 is a schematic sectional view of a semiconductor light emitting device of the embodiment;
FIGS. 3A and 3B are schematic plan views showing the semiconductor light emitting device of the embodiment;
FIG. 4 is a schematic sectional view of a semiconductor light emitting device of the embodiment;
FIG. 5 is a schematic plan view of the semiconductor light emitting device of the embodiment;
FIG. 6 is a schematic sectional view of a semiconductor layer of the embodiment;
FIG. 7 is a schematic sectional view of a semiconductor light emitting device of the embodiment;
FIG. 8 is a schematic view of an apparatus for forming the phosphor layer of the embodiment;
FIG. 9 is an enlarged schematic sectional view of part of a phosphor layer of the embodiment; and
FIG. 10 is an enlarged schematic sectional view of part of a phosphor layer of the embodiment.

### DETAILED DESCRIPTION

According to one embodiment, a semiconductor light emitting device includes a light emitting element and a phosphor layer provided on the light emitting element. The phosphor layer includes a plurality of phosphor particles and a plurality of inorganic particles having smaller sizes than the phosphor particles. The phosphor particles are bound together with aggregation of the inorganic particles and the phosphor particles. The thermal conductivities of the inorganic particles are 20 W/m·K or more.

Embodiments will now be described with reference to the drawings. In the drawings, like components are labeled with like reference numerals.

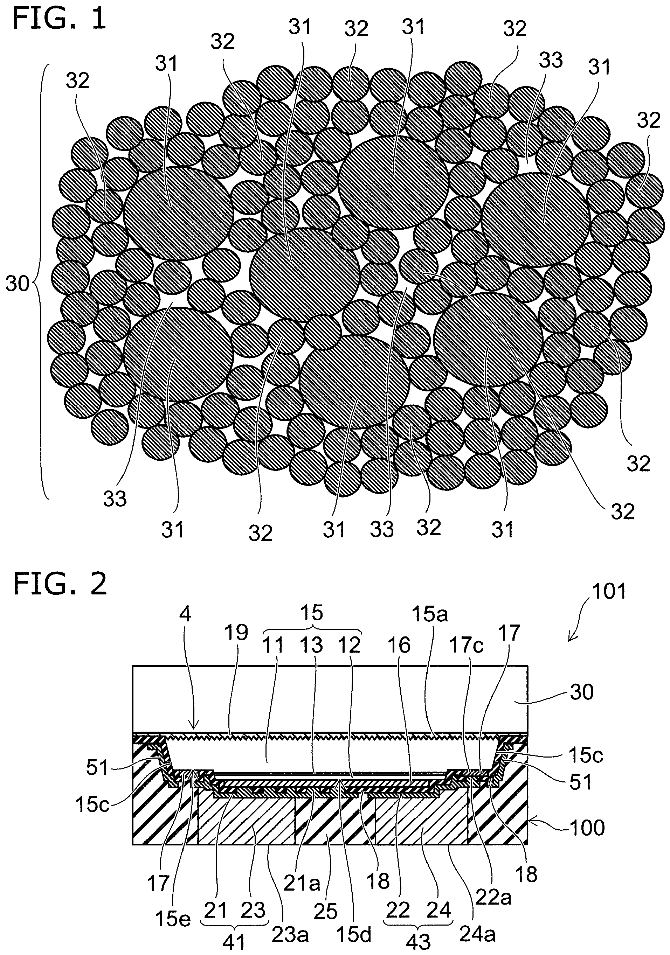

FIG. 2 is a schematic sectional view of a semiconductor light emitting device 101 of a first embodiment.

The semiconductor light emitting device 101 includes a light emitting element 4, a support body 100, and a phosphor layer 30. The light emitting element 4 is provided between the support body 100 and the phosphor layer 30.

The light emitting element 4 includes a semiconductor layer 15 containing nitride semiconductor. In this specification, the "nitride semiconductor" contains group III-V compound semiconductors of BₓIn_{y}Al_{z}Ga_{1-x-y-z}N (0≤x≤1, 0≤y≤1, 0≤z≤1, 0≤x+y+z≤1). The "nitride semiconductor" may be a mixed crystal containing other group V elements such as phosphorus (P) and arsenic (As) in addition to N (nitrogen). Furthermore, the "nitride semiconductor" may contain various elements added to control various material properties such as conductivity type, and various unintended elements.

The semiconductor layer 15 includes a first layer 11 including an n-type cladding layer, a second layer 12 including a p-type cladding layer, and a light emitting layer (active layer) 13 provided between the first layer 11 and the second layer 12.

The n-type cladding layer is, for example, an n-type GaN layer. The n-type cladding layer supplies electrons to the light emitting layer 13 under forward bias to the p-n junction. The p-type cladding layer is, for example, a p-type GaN layer. The p-type cladding layer supplies holes to the light emitting layer 13 under forward bias to the p-n junction.

The light emitting layer 13 has, for example, a multiple quantum well (MQW) structure in which a plurality of well layers and a plurality of barrier layers are alternately stacked. The well layer has lower bandgap energy than the n-type cladding layer and the p-type cladding layer. The well layer is interposed between the barrier layers in the stacking direction. The barrier layer has higher bandgap energy than the well layer. The well layer contains, for example, InGaN. The barrier layer contains, for example, GaN. The barrier layer does not substantially contain In. Alternatively, the barrier layer may contain In. In the case where the barrier layer contains In, the In composition ratio in the barrier layer is lower than the In composition ratio in the well layer. The range of the peak wavelength of light emitted from the light emitting layer 13 is, for example, 360 nm or more and 650 nm or less.

The phosphor layer 30 is provided on the first surface 15a side of the semiconductor layer 15 via a transparent inorganic film 19.

The semiconductor layer 15 is epitaxially grown on a monocrystalline substrate (hereinafter simply referred to as substrate) such as a silicon substrate, sapphire substrate, silicon carbide substrate, and gallium oxide substrate. The first layer 11, the light emitting layer 13, and the second layer 12 are sequentially formed on the substrate. The substrate used for formation (growth) of the semiconductor layer 15 is removed from the semiconductor layer 15.

Fine asperities are formed at the first surface 15a of the first layer 11 exposed by the removal of the substrate. For example, an asperity surface is formed by wet etching with an alkali-based solution. This asperity surface reduces the reflective component traveling back into the semiconductor layer 15. This can improve the efficiency of light extraction from the semiconductor layer 15 to the transparent inorganic film 19 side.

FIG. 1 is an enlarged schematic sectional view of part of the phosphor layer 30.

The phosphor layer 30 includes a plurality of phosphor particles 31 and a plurality of inorganic particles 32. The phosphor particle 31 is excited by emission light (excitation light) of the light emitting layer 13 and emits light of a wavelength different from the wavelength of the excitation light. Light of white color or incandescent color is artificially obtained as mixed light of the light of the light emitting layer 13 and the light of the phosphor particles 31.

The size of the inorganic particle 32 is smaller than the size of the phosphor particle 31. Here, the size of a particle refers to the average particle diameter of a plurality of particles, or the peak particle diameter in the particle diameter distribution.

A plurality of fine inorganic particles 32 are aggregated among the phosphor particles 31 and bind together the phosphor particles 31. One phosphor particle 31 is surrounded with the inorganic particles 32. The phosphor particles 31 and the inorganic particles 32 are aggregated and brought into contact with each other without the intermediary of resin. Thus, the phosphor particles 31 are bound together. The inorganic particles 32 are aggregated and brought into contact with each other without the intermediary of resin. Thus, the inorganic particles 32 are bound together.

The phosphor layer 30 of the embodiment is not a sintered body in which the phosphor particles 31 are bound by resin or inorganic binder. Instead, as described later, the phosphor layer 30 is an aggregate of the phosphor particles 31 and the inorganic particles 32. The aggregate is formed by aerosol deposition technique or volatilization of a solvent. The phosphor layer 30 includes no resin. The layer of the aggregate of the phosphor particles 31 and the inorganic particles 32 is formed.

Voids 33 are formed among the inorganic particles 32, and between the inorganic particles 32 and the phosphor particles 31. The inorganic particles 32 functioning as binder for binding together the phosphor particles 31 is not a sintered body. Thus, a grain boundary exists among the inorganic particles 32.

The inorganic particle 32 is transmissive to emission light of the light emitting layer 13 and emission light of the phosphor particles 31. Here, the term "transmissive" is not limited to a transmittance of 100%, but also includes the case of partially absorbing light.

The inorganic particle 32 has a higher thermal conductivity than resin and silicon oxide. The thermal conductivity of the inorganic particle 32 is 20 W/m·K or more. For example, the inorganic particle 32 can be composed primarily of aluminum oxide (Al₂O₃), silicon nitride (Si₃N₄), or silicon carbide (SiC).

The phosphor particle 31 emitting light generates heat by the amount of wavelength conversion loss (Stokes loss). Here, in a structure in which phosphor particles 31 are dispersed in binder resin, the resin may deteriorate or decompose by the heat of the phosphor particles 31. Heat resistance of resin may become a problem particularly in high-power light emitting elements.

According to the embodiment, the phosphor layer 30 does not use resin as binder. This can improve the heat resistance of the phosphor layer 30. Furthermore, heat of the phosphor particles 31 can be dissipated to the outside of the phosphor layer 30 by the inorganic particles 32 having high thermal conductivity. For instance, heat of the phosphor particles 31 is dissipated to the mounting substrate through the light emitting element 4 and the metal pillars 23, 24 of the support body 100 shown in FIG. 2.

According to the embodiment, there is no high temperature treatment for sintering the phosphor layer 30 on the light emitting element 4. This can improve the reliability of the light emitting element 4. Furthermore, the phosphor layer 30 is not laminated with the light emitting element 4 via a resin adhesive (resin film). There is no resin in the heat dissipation path between the phosphor layer 30 and the light emitting element 4. This enhances the heat dissipation capability of the phosphor layer 30. Furthermore, there is no problem of resin degradation due to heat of the phosphor layer 30.

Furthermore, the inorganic particles 32 having higher Young's modulus than resin are used as binder. This can reduce the coefficient of thermal expansion of the phosphor layer 30. Thus, the stress applied from the phosphor layer 30 to the semiconductor layer 15 can be relaxed. This enhances the reliability of the semiconductor layer 15.

As described above, the embodiment can provide a semiconductor light emitting device being superior in heat dissipation capability of the phosphor layer 30 and having high reliability.

In the embodiment, the phosphor particle 31 can be made of e.g. an oxide-based phosphor such as Y₃Al₅O₁₂, Ba₂SiO₄: Eu²⁺, and SrBaSiO₄: Eu²⁺, a sulfide-based phosphor such as ZnS: (Cu⁺,Al³⁺), SrS:Eu²⁺, CaS:Eu²⁺, and SrGa₂S₄: Eu²⁺, an oxysulfide-based phosphor such as Y₂O₂S:Eu³⁺, a halide-based phosphor such as M₃(PO₄)₃Cl: Eu²⁺ (M being Sr, Ca, Ba, or Mg), or an aluminate-based phosphor such as BaMgAl₁₀O₁₇: (Eu²⁺,Mn²⁺) and SrAl₂O₄: Eu²⁺.

Alternatively, the phosphor particle 31 can be made of e.g. calcium magnesium chlorosilicate doped with Eu represented by the chemical formula Ca₈₋ₓEuₓMg_{1-y}Mn_{y}(SiO₄)₄Cl₂ (0<x≤8, 0≤y≤1). The ratio y of manganese (Mn) is preferably 0≤y≤0.2.

Alternatively, the phosphor particle 31 can be made of e.g. a strontium silicate-based phosphor represented by the chemical formula (Sr_{1-x-y}Ba_{y}Euₓ)₃(Si_{1-z}Ge_{z})₅ (0<x≤0.1, 0≤y≤1, 0≤z≤0.1).

Alternatively, the phosphor particle 31 can be made of e.g. a sialon-based phosphor represented by the chemical formula (M₁₋ₓ,Rₓ)ₐ₁AlSi_{b1}O_{c1}N_{d1}. Here, M is at least one metallic element except Si and Al, and preferably at least one of Ca and Sr. R is an emission center element, and preferably Eu. The values x, a1, b1, c1, and d1 satisfy the following relations.
0<x≤1,
0.6<a1<0.95,
2<b1<3.9,
0.25<c1<0.45,
4<d1<5.7

Alternatively, the phosphor particle 31 can be made of e.g. a sialon-based phosphor represented by the chemical formula (M₁₋ₓ,Rₓ)ₐ₂AlSi_{b2}O_{c2}N_{d2}. Here, M is at least one metallic element except Si and Al, and preferably at least one of Ca and Sr. R is an emission center element, and preferably Eu. The values x, a2, b2, c2, and d2 satisfy the following relations.
0<x≤1,
0.93<a2<1.3,
4.0<b2<5.8,
0.6<c2<1,
6<d2<11

It is understood that the phosphor particle 31 is not limited to being made of a single phosphor material, but may be made of a mixture of a plurality of kinds of phosphor materials, including phosphor materials other than the aforementioned phosphor materials.

Next, other components of the semiconductor light emitting device 101 are described with reference again to FIG. 2.

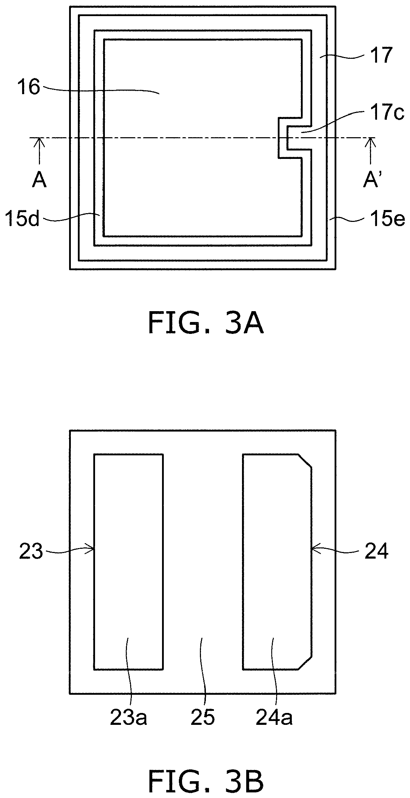

FIG. 3A is a schematic plan view showing an example of the planar layout of some components in the semiconductor light emitting device 101. FIG. 2 corresponds to A-A' cross section in FIG. 3A.

FIG. 3B is a schematic plan view of the mounting surface (the lower surface in FIG. 2) of the semiconductor light emitting device 101.

As described above, the semiconductor layer 15 includes a first layer 11, a second layer 12, and a light emitting layer 13 provided between the first layer 11 and the second layer 12. The first layer 11 has a first surface (asperity surface) 15a.

The semiconductor layer 15 includes a portion 15d and a portion 15e. The portion 15d includes a stacked film of the light emitting layer 13 and the second layer 12. The portion 15e does not include the light emitting layer 13 and the second layer 12. The portion 15d is a portion of the semiconductor layer 15 in which the light emitting layer 13 is stacked. The portion 15e is a portion of the semiconductor layer 15 in which the light emitting layer 13 is not stacked.

A p-side electrode 16 is provided on the surface of the second layer 12 of the portion 15d including the light emitting layer 13. An n-side electrode 17 is provided on the surface of the first layer 11 of the portion 15e not including the light emitting layer 13. The p-side electrode 16 and the n-side electrode 17 are provided on the opposite side from the first surface 15a.

In the example shown in FIG. 3A, the portion 15e not including the light emitting layer 13 surrounds the portion 15d including the light emitting layer 13. The n-side electrode 17 surrounds the p-side electrode 16.

The area of the portion 15d including the light emitting layer 13 is larger than the area of the portion 15e not including the light emitting layer 13. The area of the p-side electrode 16 provided on the surface of the portion 15d including the light emitting layer 13 is larger than the area of the n-side electrode 17 provided on the surface of the portion 15e not including the light emitting layer 13. Thus, a large light emitting surface is obtained. This can increase the optical output.

As shown in FIG. 3A, the n-side electrode 17 includes e.g. four linear parts. Among them, one linear part includes a contact part 17c projected in the width direction of the linear part. A via 22a of the n-side wiring layer 22 is connected to the surface of the contact part 17c as shown in FIG. 2.

A support body 100 is provided on the opposite side of the semiconductor layer 15 from the first surface 15a. The light emitting element 4 including the semiconductor layer 15, the p-side electrode 16, and the n-side electrode 17 is supported by the support body 100.

The aforementioned phosphor layer 30 is provided on the first surface 15a side of the semiconductor layer 15. A transparent inorganic film 19 is provided between the first surface 15a of the semiconductor layer 15 and the phosphor layer 30. The transparent inorganic film 19 enhances adhesiveness between the semiconductor layer 15 and the phosphor layer 30.

The opposite side (second surface side) of the semiconductor layer 15 from the first surface 15a, the p-side electrode 16, and the n-side electrode 17 are covered with an insulating film 18. The insulating film 18 is e.g. an inorganic insulating film such as silicon oxide film. The insulating film 18 is provided also on the side surface of the light emitting layer 13 and the side surface of the second layer 12. The insulating film 18 covers the side surface of the light emitting layer 13 and the side surface of the second layer 12. The insulating film 18 is provided also on the side surface 15c of the first layer 11 continued from the first surface 15a. The insulating film 18 covers the side surface 15c.

A p-side wiring layer 21 and an n-side wiring layer 22 are provided on the insulating film 18 and separated from each other. A plurality of first openings communicating with the p-side electrode 16 and a second opening communicating with the contact part 17c of the n-side electrode 17 are formed in the insulating film 18. Alternatively, the first openings may be one larger opening.

The p-side wiring layer 21 is provided on the insulating film 18 and inside the first opening. The p-side wiring layer 21 is electrically connected to the p-side electrode 16 through a via 21a provided in the first opening.

The n-side wiring layer 22 is provided on the insulating film 18 and inside the second opening. The n-side wiring layer 22 is electrically connected to the contact part 17c of the n-side electrode 17 through a via 22a provided in the second opening.

The p-side wiring layer 21 and the n-side wiring layer 22 occupy a large proportion of the second surface side of the semiconductor layer 15 and spread on the insulating film 18. The p-side wiring layer 21 is connected to the p-side electrode 16 through a plurality of vias 21a.

A reflective film 51 covers the side surface 15c of the semiconductor layer 15 via the insulating film 18. The reflective film 51 is not in contact with the side surface 15c. The reflective film 51 is not electrically connected to the semiconductor layer 15. The reflective film 51 is separated from the p-side wiring layer 21 and the n-side wiring layer 22. The reflective film 51 is a metal film reflective to emission light of the light emitting layer 13 and emission light of the phosphor 31.

The reflective film 51, the p-side wiring layer 21, and the n-side wiring layer 22 are simultaneously formed on a common metal film by e.g. plating technique. The reflective film 51, the p-side wiring layer 21, and the n-side wiring layer 22 include e.g. a copper film. The copper film is formed by plating technique on the metal film formed on the insulating film 18.

The metal film underlying the p-side wiring layer 21 and the n-side wiring layer 22 includes e.g. an aluminum film. The aluminum film has high reflectance to emission light of the light emitting layer 13. The aluminum film is formed over a large proportion of the second surface side of the semiconductor layer 15. This can increase the amount of light directed to the phosphor layer 30 side.

A p-side metal pillar 23 is provided on the surface of the p-side wiring layer 21 on the opposite side from the semiconductor layer 15. A p-side wiring section 41 includes the p-side wiring layer 21 and the p-side metal pillar 23.

An n-side metal pillar 24 is provided on the surface of the n-side wiring layer 22 on the opposite side from the semiconductor layer 15. An n-side wiring section 43 includes the n-side wiring layer 22 and the n-side metal pillar 24.

A resin layer 25 is provided as an insulating layer between the p-side wiring section 41 and the n-side wiring section 43. The resin layer 25 is provided on the side surface of the p-side wiring section 41 and the side surface of the n-side wiring section 43.

The resin layer 25 is provided between the p-side metal pillar 23 and the n-side metal pillar 24 so as to be in contact with the side surface of the p-side metal pillar 23 and the side surface of the n-side metal pillar 24. The resin layer 25 is filled between the p-side metal pillar 23 and the n-side metal pillar 24.

The resin layer 25 is provided between the p-side wiring layer 21 and the n-side wiring layer 22, between the p-side wiring layer 21 and the reflective film 51, and between the n-side wiring layer 22 and the reflective film 51. The resin layer 25 is provided around the p-side metal pillar 23 and around the n-side metal pillar 24. The resin layer 25 covers the side surface of the p-side metal pillar 23 and the side surface of the n-side metal pillar 24.

The resin layer 25 is provided also in the region (chip outer peripheral part) adjacent to the side surface 15c of the semiconductor layer 15. The resin layer 25 covers the reflective film 51.

The end part (surface) of the p-side metal pillar 23 on the opposite side from the p-side wiring layer 21 is exposed from the resin layer 25. The end part functions as a p-side external terminal 23a connectable to an external circuit of e.g. the mounting substrate. The end part (surface) of the n-side metal pillar 24 on the opposite side from the n-side wiring layer 22 is exposed from the resin layer 25. The end part functions as an n-side external terminal 24a connectable to an external circuit of e.g. the mounting substrate. The p-side external terminal 23a and the n-side external terminal 24a are bonded to pads of the mounting substrate through e.g. solder or a conductive bonding material.

As shown in FIG. 3B, the p-side external terminal 23a and the n-side external terminal 24a are juxtaposed and spaced from each other in the same surface (lower surface) of the resin layer 25. The p-side external terminal 23a is formed in e.g. a rectangular shape. The n-side external terminal 24a is formed in a rectangular shape of the same size as the rectangle of the p-side external terminal 23a except that two corners are chamfered. This enables determination of the polarity of the external terminals. Alternatively, the n-side external terminal 24a may be shaped like a rectangle, and the p-side external terminal 23a may be shaped like a rectangle with chamfered corners.

The spacing between the p-side external terminal 23a and the n-side external terminal 24a is wider than the spacing between the p-side wiring layer 21 and the n-side wiring layer 22 on the insulating film 18. The spacing between the p-side external terminal 23a and the n-side external terminal 24a is made larger than the spread of solder at the time of mounting. This can prevent short circuit between the p-side external terminal 23a and the n-side external terminal 24a through solder.

In contrast, the spacing between the p-side wiring layer 21 and the n-side wiring layer 22 can be narrowed to the process limit. This can expand the area of the p-side wiring layer 21, and the contact area between the p-side wiring layer 21 and the p-side metal pillar 23. Thus, heat dissipation of the light emitting layer 13 can be facilitated.

The area of the p-side wiring layer 21 in contact with the p-side electrode 16 through a plurality of vias 21a is larger than the area of the n-side wiring layer 22 in contact with the n-side electrode 17 through the via 22a. Thus, the distribution of current flowing in the light emitting layer 13 can be made uniform.

The area of the n-side wiring layer 22 spread on the insulating film 18 can be made larger than the area of the n-side electrode 17. The area of the n-side metal pillar 24 provided on the n-side wiring layer 22 (the area of the n-side external terminal 24a) can be made larger than that of the n-side electrode 17. This can reduce the area of the n-side electrode 17 while ensuring the area of the n-side external terminal 24a sufficient for mounting with high reliability. That is, optical output can be improved by reducing the area of the portion 15e of the semiconductor layer 15 not including the light emitting layer 13 and expanding the area of the portion 15d including the light emitting layer 13.

The first layer 11 is electrically connected to the n-side metal pillar 24 through the n-side electrode 17 and the n-side wiring layer 22. The second layer 12 is electrically connected to the p-side metal pillar 23 through the p-side electrode 16 and the p-side wiring layer 21.

The thickness of the p-side metal pillar 23 (the thickness in the direction connecting the p-side wiring layer 21 and the p-side external terminal 23a) is thicker than the thickness of the p-side wiring layer 21. The thickness of the n-side metal pillar 24 (the thickness in the direction connecting the n-side wiring layer 22 and the n-side external terminal 24a) is thicker than the thickness of the n-side wiring layer 22. Each thickness of the p-side metal pillar 23, the n-side metal pillar 24, and the resin layer 25 is thicker than that of the semiconductor layer 15.

The aspect ratio (ratio of thickness to planar size) of the metal pillar 23, 24 may be 1 or more, or smaller than 1. That is, the metal pillar 23, 24 may be thicker or thinner than the planar size thereof.

The thickness of the support body 100 including the p-side wiring layer 21, the n-side wiring layer 22, the p-side metal pillar 23, the n-side metal pillar 24, and the resin layer 25 is thicker than the thickness of the light emitting element (LED chip) 4 including the semiconductor layer 15, the p-side electrode 16, and the n-side electrode 17.

The semiconductor layer 15 is formed on the substrate by epitaxial growth technique. In the example shown in FIG. 2, the substrate is removed after the support body 100 is formed. Thus, the semiconductor layer 15 does not include the substrate on the first surface 15a side. The semiconductor layer 15 is supported not by a rigid plate-like substrate, but by the support body 100 made of a composite of the metal pillars 23, 24 and the resin layer 25.

The material of the p-side wiring section 41 and the n-side wiring section 43 can be e.g. copper, gold, nickel, or silver. Among them, copper can achieve good thermal conductivity, high migration resistance, and good adhesiveness to insulating material.

The resin layer 25 reinforces the p-side metal pillar 23 and the n-side metal pillar 24. The resin layer 25 is preferably made of a material having a thermal expansion rate equal or close to that of the semiconductor layer 15. Such a resin layer 25 can be made of a composite material in which e.g. silica filler is mixed in a resin primarily containing epoxy resin, a resin primarily containing silicone resin, or a resin primarily containing fluororesin.

The base resin of the resin layer 25 may include e.g. a light-absorbing agent, a light-reflecting agent, or a light-scattering agent. Thus, the resin layer 25 can have light blocking capability or reflectivity to light of the light emitting layer 13. This can suppress light leakage from the side surface and the mounting surface side of the support body 100.

By the thermal cycle at the time of mounting of the semiconductor light emitting device, the semiconductor layer 15 is subjected to stress due to e.g. solder for bonding the p-side external terminal 23a and the n-side external terminal 24a to the pads of the mounting substrate. The p-side metal pillar 23, the n-side metal pillar 24, and the resin layer 25 absorb and relax the stress. In particular, the resin layer 25 softer than the semiconductor layer 15 is used as part of the support body 100. This can enhance the stress relaxation effect.

The reflective film 51 is separated from the p-side wiring section 41 and the n-side wiring section 43. Thus, the stress applied to the p-side metal pillar 23 and the n-side metal pillar 24 at the time of mounting is not transmitted to the reflective film 51. This can suppress peeling of the reflective film 51. Furthermore, this can suppress stress applied to the side surface 15c side of the semiconductor layer 15.

The phosphor layer 30 is not formed on the second surface side of the semiconductor layer 15, around the metal pillars 23, 24, and on the side surface of the support body 100. The side surface of the phosphor layer 30 is aligned with the side surface of the support body 100 (the side surface of the resin layer 25). The side surface of the phosphor layer 30 and the side surface of the support body 100 (the side surface of the resin layer 25) are continuous on the same plane.

That is, the semiconductor light emitting device 101 shown in FIG. 2 is a semiconductor light emitting device of the chip-size package structure having a very small size.

Light is not extracted outside from the mounting surface side. The phosphor layer 30 is not formed uselessly on the mounting surface side. This can reduce the cost. Heat of the light emitting layer 13 can be dissipated to the mounting substrate side through the p-side wiring layer 21, the n-side wiring layer 22, and the thick metal pillars 23, 24 spread on the second surface side. Thus, the semiconductor light emitting device 101 is superior in heat dissipation capability in spite of its small size.

In the typical flip-chip mounting, an LED chip is mounted on the mounting substrate via e.g. bumps. Then, a phosphor layer is formed so as to entirely cover the chip. Alternatively, resin is underfilled between the bumps.

In contrast, according to the embodiment, the resin layer 25 different from the phosphor layer 30 is provided around the p-side metal pillar 23 and around the n-side metal pillar 24 before mounting. This can provide the mounting surface side with characteristics suitable for stress relaxation. Furthermore, the resin layer 25 already provided on the mounting surface side dispenses with underfilling after mounting.

The phosphor layer 30 designed preferentially for light extraction efficiency, color conversion efficiency, and light distribution characteristics is provided on the first surface 15a side. Layers designed preferentially for stress relaxation at the time of mounting and characteristics for a support body replacing the substrate are provided on the mounting surface side. For instance, the resin layer 25 can be filled with a filler such as silica particles at high density. Thus, the hardness of the resin layer 25 can be adjusted to a level suitable for a support body.

Light emitted from the light emitting layer 13 to the first surface 15a side is incident on the phosphor layer 30. Part of the light excites the phosphor particles 31. For instance, white light is artificially obtained as mixed light of the light of the light emitting layer 13 and the light of the phosphor particles 31.

Here, if a substrate exists on the first surface 15a, part of the light fails to be incident on the phosphor layer 30 and leaks outside from the side surface of the substrate. That is, light of a strong color of the light emitting layer 13 leaks from the side surface of the substrate. This may cause color breakup or color unevenness such as a phenomenon in which a ring of blue light appears on the outer edge side of the phosphor layer 30 as viewed from above the upper surface.

In contrast, according to the embodiment, there is no substrate between the first surface 15a and the phosphor layer 30. This can prevent color breakup or color unevenness caused by leakage of light of a strong color of the light emitting layer 13 from the substrate side surface.

Furthermore, the reflective film 51 is provided on the side surface 15c of the first layer 11 via the insulating film 18. Light directed from the light emitting layer 13 toward the side surface 15c of the first layer 11 is reflected by the reflective film 51, and does not leak outside. This can prevent color breakup or color unevenness caused by light leakage from the side surface side of the semiconductor light emitting device 101 in combination with the absence of a substrate on the first surface 15a side.

The insulating film 18 is provided between the reflective film 51 and the side surface 15c of the first layer 11. The insulating film 18 prevents diffusion of the metal contained in the reflective film 51 to the first layer 11. This can prevent metal contamination of e.g. GaN contained in the first layer 11. Thus, degradation of the first layer 11 can be prevented.

Next, a method for forming the phosphor layer 30 is described.

The phosphor layer 30 can be formed by e.g. aerosol deposition technique.

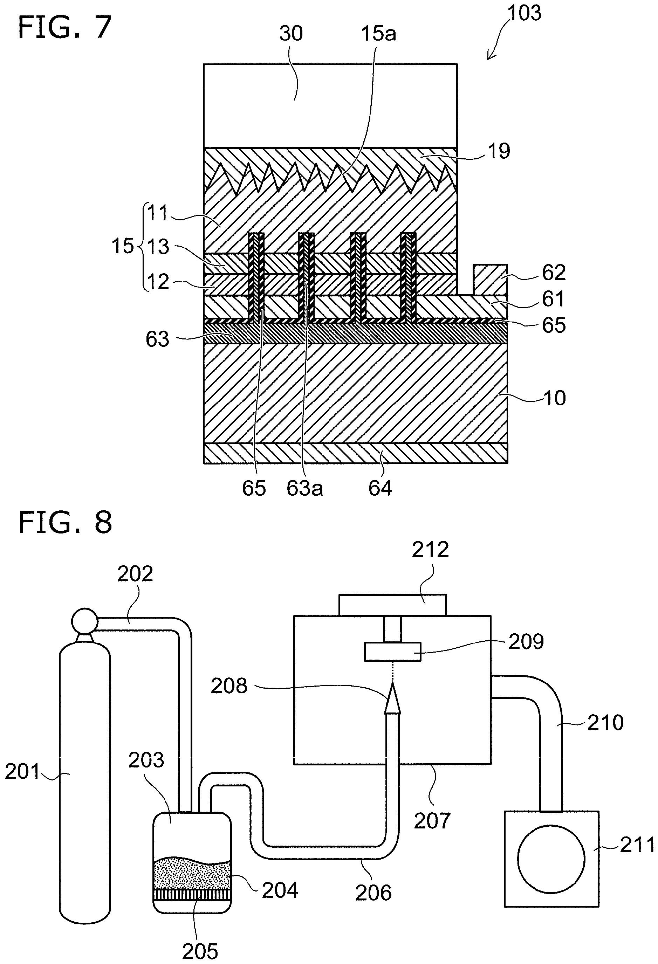

FIG. 8 is a schematic view of an example of an aerosol deposition apparatus.

A support body 100 including metal pillars 23, 24 and a resin layer 25 is formed in the wafer state including a plurality of light emitting elements 4. Then, the substrate used for growth of the semiconductor layer 15 is removed. After the substrate is removed, the wafer 209 is set in a deposition chamber 207. The wafer 209 is held by a stage 212 provided outside the deposition chamber 207. The deposition chamber 207 is connected to a vacuum pump 211 through an exhaust pipe 210 and filled with a reduced-pressure atmosphere having a lower pressure than the aerosol chamber 203.

Phosphor particles 31 and inorganic particles 32 are mixed into source particles 204. The source particles 204 are set in the aerosol chamber 203. A carrier gas such as helium, argon, and nitrogen is supplied from a high-pressure gas cylinder 201 through a gas supply pipe 202 into the aerosol chamber 203. The source particles 204 and the carrier gas are stirred and mixed into an aerosol by the aerosol generator 205.

By the pressure difference between the aerosol chamber 203 and the deposition chamber 207, the aerosolized source particles 204 are transported with the carrier gas in a transport pipe 206. The source particles 204 are sprayed toward the wafer 209 from a nozzle 208 set in the deposition chamber 207. The aerosolized source particles 204 are sprayed toward the first surface 15a of the semiconductor layer 15 or the transparent inorganic film 19 formed on the first surface 15a in the wafer 209.

At this time, the kinetic energy of the aerosolized source particles 204 is converted to the energy for binding particles on the wafer 209 and the energy for attaching the particles to the wafer. Thus, an aggregate of a plurality of phosphor particles 31 and a plurality of inorganic particles 32 is formed like a layer on the first surface 15a.

Here, the embodiment is not limited to the case where phosphor particles 31 and inorganic particles 32 are mixed and sprayed to the wafer 209. Phosphor particles 31 and inorganic particles 32 may be separately sprayed to form an aggregate on the wafer 209.

In contrast to sintering the phosphor layer 30 at high temperature, the aerosol deposition technique can bombard and attach source particles to the wafer in the solid state at normal temperature.

An alternative method for forming the phosphor layer 30 is to utilize volatilization of a solvent.

A plurality of phosphor particles 31 and a plurality of inorganic particles 32 are dispersed in a low-viscosity solvent to form a solution (slurry). The solution is supplied onto the wafer by e.g. spin coating technique, printing technique, or dispensing technique. Then, the solvent is volatilized to form an aggregate of a plurality of phosphor particles 31 and a plurality of inorganic particles 32 on the wafer.

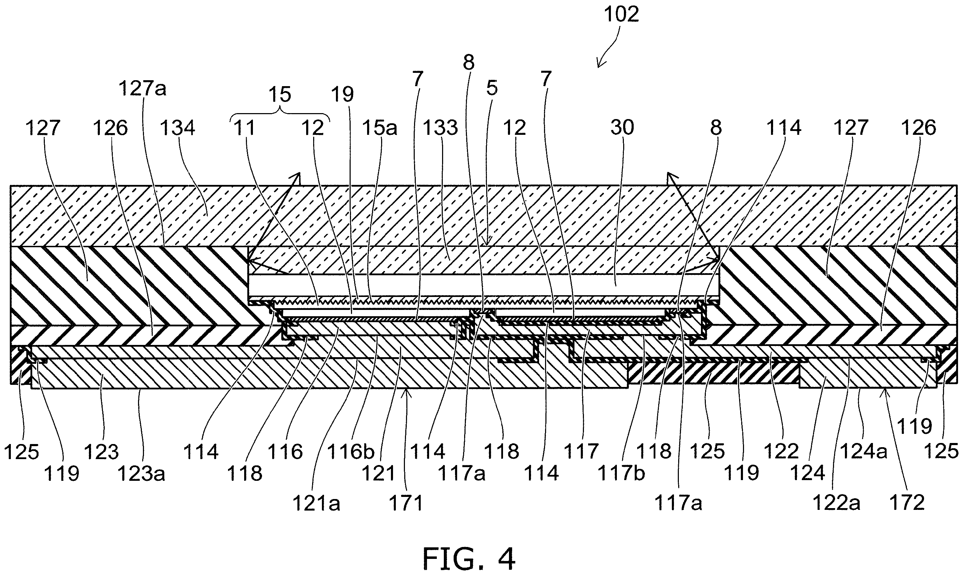

Next, a semiconductor light emitting device 102 of a second embodiment is described with reference to FIGS. 4 to 6.

FIG. 4 is a schematic sectional view of a semiconductor light emitting device 102 of a second embodiment.

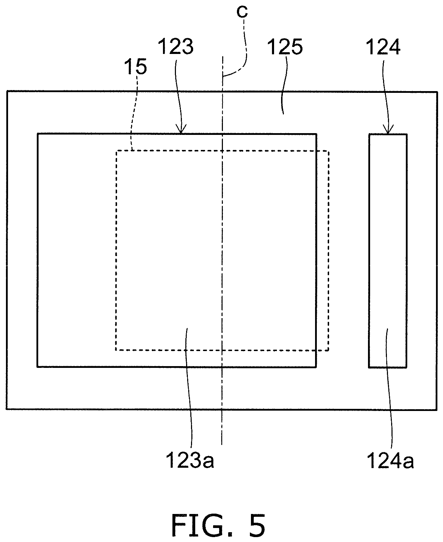

FIG. 5 is a schematic plan view of the mounting surface side of the semiconductor light emitting device 102. FIG. 5 corresponds to a bottom view of FIG. 4.

The semiconductor light emitting device 102 includes a chip-size light emitting element (LED chip) 5 formed in the wafer level, an insulating member 127 provided around the light emitting element 5, and metal layers 171, 172 provided on the mounting surface side.

The light emitting element 5 includes electrodes 7, 8, first wiring layers (on-chip wiring layers) 116, 117, optical layers 30, 133, and a semiconductor layer 15 provided between the first wiring layer 116, 117 and the optical layer 30, 133.

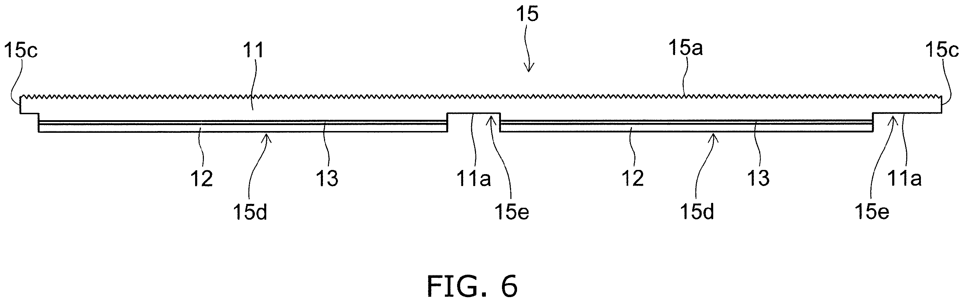

FIG. 6 is an enlarged schematic sectional view of the semiconductor layer 15.

As described above, the semiconductor layer 15 includes a first layer 11, a second layer 12, and a light emitting layer 13 provided between the first layer 11 and the second layer 12.

The semiconductor layer 15 includes a first portion 15d and a second portion 15e. The first portion 15d includes a stacked film of the second layer 12 and the light emitting layer 13. The second portion 15e has a second surface 11a of the first layer 11 not covered with the light emitting layer 13 and the second layer 12.

For instance, the second portion 15e is formed like an island surrounded with the first portion 15d. Furthermore, the second portion 15e is formed so as to continuously surround the first portion 15d on the outer peripheral side of the first portion 15d. The area of the first portion 15d including the light emitting layer 13 is larger than the area of the second portion 15e not including the light emitting layer 13.

A first surface (asperity surface) 15a is formed on the opposite side of the first layer 11 from the second surface 11a. The first surface 15a is not covered with the light emitting layer 13 and the second layer 12. The semiconductor layer 15 has a side surface 15c continued to the first surface 15a.

The n-side electrode 8 shown in FIG. 4 is provided on the second surface 11a of the first layer 11. The p-side electrode 7 shown in FIG. 4 is provided on the surface of the second layer 12. The p-side electrode 7 and the n-side electrode 8 are formed within the region (chip region) overlapping the semiconductor layer 15.

The area of the p-side electrode 7 is larger than the area of the n-side electrode 8. The contact area between the p-side electrode 7 and the second layer 12 is larger than the contact area between the n-side electrode 8 and the first layer 11.

An insulating film 114 is provided on the surface of the semiconductor layer 15 other than the first surface 15a. The insulating film 114 is an inorganic film such as silicon oxide film.

A p-side opening communicating with the p-side electrode 7 and an n-side opening communicating with the n-side electrode 8 are formed in the insulating film 114. For instance, two n-side openings are formed and spaced from each other. The surface of the p-side electrode 7 between the two n-side openings is covered with the insulating film 114.

The side surface 15c of the first layer 11, the side surface of the second layer 12, and the side surface of the light emitting layer 13 are covered with the insulating film 114.

A first p-side wiring layer 116 and a first n-side wiring layer 117 are provided on the opposite side of the semiconductor layer 15 from the first surface 15a.

The first p-side wiring layer 116 is formed within the region (chip region) overlapping the semiconductor layer 15. The first p-side wiring layer 116 is provided also in the p-side opening and in contact with the p-side electrode 7. The first p-side wiring layer 116 is connected to the p-side electrode 7 through a contact part formed integrally therewith in the p-side opening. The first p-side wiring layer 116 is not in contact with the first layer 11.

The first n-side wiring layer 117 is formed within the region (chip region) overlapping the semiconductor layer 15. The first n-side wiring layer 117 is provided also in the n-side opening and in contact with the n-side electrode 8. The first n-side wiring layer 117 is connected to the n-side electrode 8 through a contact part 117a formed integrally therewith in the n-side opening.

The first n-side wiring layer 117 is formed in e.g. a line pattern extending in the direction connecting two island-shaped n-side electrodes 8. The insulating film 114 is provided between the p-side electrode 7 and the portion of the first n-side wiring layer 117 between the two n-side electrodes 8, and between the second layer 12 and the portion of the first n-side wiring layer 117 between the two n-side electrodes 8. The first n-side wiring layer 117 is not in contact with the p-side electrode 7 and the second layer 12.

The p-side electrode 7 is provided between the second layer 12 and the first p-side wiring layer 116. For instance, the p-side electrode 7 includes a silver (Ag) film having high reflectance to light emitted by the light emitting layer 13 and the phosphor particles 31.

The n-side electrode 8 is provided between the first layer 11 and the contact part 117a of the first n-side wiring layer 117. For instance, the n-side electrode 8 includes an aluminum (Al) film having high reflectance to light emitted by the light emitting layer 13 and the phosphor particles 31.

An insulating film 118 is provided on the surface of the first p-side wiring layer 116 and the first n-side wiring layer 117. The insulating film 118 is provided also between first p-side wiring layer 116 and the first n-side wiring layer 117. The insulating film 118 is e.g. an inorganic film such as silicon oxide film.

A p-side opening and an n-side opening are formed in the insulating film 118. The p-side opening exposes part (p-side pad 116b) of the first p-side wiring layer 116. The n-side opening exposes part (n-side pad 117b) of the first n-side wiring layer 117.

The area of the p-side pad 116b is larger than the area of the n-side pad 117b. The area of the n-side pad 117b is larger than the contact area between the first n-side wiring layer 117 and the n-side electrode 8.

A phosphor layer 30 is provided on the first surface 15a side of the semiconductor layer 15. Furthermore, a transparent layer (first transparent layer) 133 is provided on the phosphor layer 30. As described above, the phosphor layer 30 is an aggregate of a plurality of phosphor particles 31 and a plurality of inorganic particles 32.

A transparent inorganic film 19 is provided between the first surface 15a and the phosphor layer 30. The transparent inorganic film 19 and the phosphor layer 30 are provided also on the insulating film 114 in the off-chip region.

The transparent layer 133 on the phosphor layer 30 is made of transparent glass or transparent resin not including phosphor particles. Alternatively, the transparent layer 133 may be caused to function as a light-scattering layer. In this case, the transparent layer 133 includes a plurality of particles of a scattering material (such as silicon oxide titanium compound, and zinc oxide), and a binding material (e.g., transparent resin or transparent glass). The scattering material scatters emission light of the light emitting layer 13. The binding material is transmissive to emission light of the light emitting layer 13.

An insulating member 127 is provided in the off-chip region outside the side surface of the semiconductor layer 15. The insulating member 127 is thicker than the semiconductor layer 15. The insulating member 127 covers the side surface of the semiconductor layer 15 via the insulating film 114.

The insulating member 127 is provided also outside the side surface of the optical layers (phosphor layer 30 and transparent layer 133). The insulating member 127 covers the side surface of the optical layers.

The insulating member 127 is provided around the light emitting element 5 including the semiconductor layer 15, the electrodes 7, 8, the first wiring layers (on-chip wiring layers) 116, 117, and the phosphor layer 30. The insulating member 127 supports the light emitting element 5.

The upper surface 127a of the insulating member 127 and the upper surface of the transparent layer 133 form a flat surface. An insulating film 126 is provided on the back surface of the insulating member 127.

A second p-side wiring layer 121 is provided on the first p-side pad 116b of the first p-side wiring layer 116. The second p-side wiring layer 121 is in contact with the first p-side pad 116b of the first p-side wiring layer 116 and extends to the off-chip region. The portion of the second p-side wiring layer 121 extending to the off-chip region is supported by the insulating member 127 via the insulating film 126.

Part of the second p-side wiring layer 121 extends also to the region overlapping the first n-side wiring layer 117 via the insulating film 118.

A second n-side wiring layer 122 is provided on the first n-side pad 117b of the first n-side wiring layer 117. The second n-side wiring layer 122 is in contact with the first n-side pad 117b of the first n-side wiring layer 117 and extends to the off-chip region. The portion of the second n-side wiring layer 122 extending to the off-chip region is supported by the insulating member 127 via the insulating film 126.

An insulating film 119 is provided on the surface of the second p-side wiring layer 121 and the second n-side wiring layer 122. The insulating film 119 is an inorganic film such as silicon oxide film.

A p-side opening and an n-side opening are formed in the insulating film 119. The p-side opening exposes the second p-side pad 121a of the second p-side wiring layer 121. The n-side opening exposes the second n-side pad 122a of the second n-side wiring layer 122.

A p-side external connection electrode 123 is provided on the second p-side pad 121a of the second p-side wiring layer 121. The p-side external connection electrode 123 is in contact with the second p-side pad 121a of the second p-side wiring layer 121 and provided on the second p-side wiring layer 121.

Part of the p-side external connection electrode 123 is provided also on the region overlapping the first n-side wiring layer 117 via the insulating films 118, 119, and the region overlapping the second n-side wiring layer 122 via the insulating film 119.

The p-side external connection electrode 123 spreads in the chip region overlapping the semiconductor layer 15, and the off-chip region. The p-side external connection electrode 123 is thicker than the first p-side wiring layer 116 and thicker than the second p-side wiring layer 121.

An n-side external connection electrode 124 is provided on the second n-side pad 122a of the second n-side wiring layer 122. The n-side external connection electrode 124 is placed in the off-chip region and in contact with the second n-side pad 122a of the second n-side wiring layer 122.

The n-side external connection electrode 124 is thicker than the first n-side wiring layer 117 and thicker than the second n-side wiring layer 122.

A resin layer (insulating layer) 125 is provided between the p-side external connection electrode 123 and the n-side external connection electrode 124. The resin layer 125 is in contact with the side surface of the p-side external connection electrode 123 and the side surface of the n-side external connection electrode 124. The resin layer 125 is filled between the p-side external connection electrode 123 and the n-side external connection electrode 124.

The resin layer 125 is provided around the p-side external connection electrode 123 and around the n-side external connection electrode 124. The resin layer 125 covers the side surface of the p-side external connection electrode 123 and the side surface of the n-side external connection electrode 124.

The resin layer 125 enhances the mechanical strength of the p-side external connection electrode 123 and the n-side external connection electrode 124. The resin layer 125 functions as a solder resist for preventing wetting and spreading of solder at the time of mounting.

The lower surface of the p-side external connection electrode 123 is exposed from the resin layer 125 and functions as a p-side mounting surface (p-side external terminal) 123a connectable to an external circuit of e.g. the mounting substrate. The lower surface of the n-side external connection electrode 124 is exposed from the resin layer 125 and functions as an n-side mounting surface (n-side external terminal) 124a connectable to an external circuit of e.g. the mounting substrate. The p-side mounting surface 123a and the n-side mounting surface 124a are bonded to a land pattern of the mounting substrate through e.g. solder or a conductive bonding material.

The p-side mounting surface 123a and the n-side mounting surface 124a are preferably projected from the surface of the resin layer 125. This stabilizes the solder shape of the connection part at the time of mounting. Thus, the reliability of mounting can be improved.

FIG. 5 shows an example of the planar layout of the p-side mounting surface 123a and the n-side mounting surface 124a.

The p-side mounting surface 123a and the n-side mounting surface 124a are placed asymmetrically with respect to the center line c bisecting the planar region of the semiconductor layer 15. The p-side mounting surface 123a is larger than the n-side mounting surface 124a.

The spacing between the p-side mounting surface 123a and the n-side mounting surface 124a is set so that solder does not bridge the gap between the p-side mounting surface 123a and the n-side mounting surface 124a at the time of mounting.

The n-side electrode contact surface (the second surface 11a of the first layer 11) in the semiconductor layer 15 is relocated in a larger region including the off-chip region by the first n-side wiring layer 117 and the second n-side wiring layer 122. This can reduce the area of the n-side electrode surface in the semiconductor layer 15 while ensuring the area of the n-side mounting surface 124a sufficient for mounting with high reliability. Thus, the area of the portion 15e not including the light emitting layer 13 in the semiconductor layer 15 can be reduced, and the area of the portion 15d including the light emitting layer 13 can be expanded. This can improve the optical output.

A p-side metal layer 171 and an n-side metal layer 172 are provided on the mounting surface side. The p-side metal layer 171 includes the first p-side wiring layer 116, the second p-side wiring layer 121, and the p-side external connection electrode 123. The n-side metal layer 172 includes the first n-side wiring layer 117, the second n-side wiring layer 122, and the n-side external connection electrode 124.

The semiconductor layer 15 is supported on the support body made of a composite of the metal layers 171, 172 and the resin layer 125. The semiconductor layer 15 is supported from the side surface side by the insulating member 127. The insulating member 127 is e.g. a resin layer thicker than the semiconductor layer 15.

The material of the metal layers 171, 172 can be e.g. copper, gold, nickel, or silver. Among them, copper can achieve good thermal conductivity, high migration resistance, and good adhesiveness to insulating material.

By the thermal cycle at the time of mounting of the semiconductor light emitting device, the semiconductor layer 15 is subjected to stress due to e.g. solder for bonding the p-side mounting surface 123a and the n-side mounting surface 124a to the lands of the mounting substrate. The p-side external connection electrode 123, the n-side external connection electrode 124, and the resin layer 125 may be formed with a suitable thickness (height). Then, the p-side external connection electrode 123, the n-side external connection electrode 124, and the resin layer 125 can absorb and relax the aforementioned stress. In particular, the resin layer 125 softer than the semiconductor layer 15 is used as part of the support body on the mounting surface side. This can enhance the stress relaxation effect.

The metal layers 171, 172 are composed primarily of e.g. copper having high thermal conductivity. Thus, a high thermal conductor spreads in a large area on the region overlapping the light emitting layer 13. Heat generated in the light emitting layer 13 is dissipated to the mounting substrate by a short path formed below the chip through the metal layers 171, 172.

In particular, the p-side mounting surface 123a of the p-side metal layer 171 connected to the stacked portion 15d including the light emitting layer 13 overlaps most of the planar region of the semiconductor layer 15 in plan view shown in FIG. 5. Thus, heat can be dissipated with high efficiency to the mounting substrate through the p-side metal layer 171.

The p-side mounting surface 123a is extended also to the off-chip region. This can enlarge the planar size of the solder bonded to the p-side mounting surface 123a. Thus, heat dissipation to the mounting substrate through the solder can be improved.

The second n-side wiring layer 122 extends to the off-chip region. Thus, the n-side mounting surface 124a can be placed in the off-chip region without the constraint of the p-side mounting surface 123a laid out over a large proportion of the region overlapping the chip. By placing the n-side mounting surface 124a in the off-chip region, the area of the n-side mounting surface 124a can be made larger than that in the case where the n-side mounting surface 124a is laid out only within the chip region.

Thus, also regarding the n-side, the planar size of the solder bonded to the n-side mounting surface 124a can be made larger to improve heat dissipation to the mounting substrate through the solder.

Light emitted from the light emitting layer 13 to the first surface 15a side is incident on the phosphor layer 30 through the transparent inorganic film 19. Part of the light excites the phosphor 31. For instance, white light is obtained as mixed light of the light of the light emitting layer 13 and the light of the phosphor particles 31.

Light emitted from the light emitting layer 13 to the mounting surface side is reflected by the p-side electrode 7 and the n-side electrode 8 and directed toward the phosphor layer 30 thereabove.

A transparent layer (first transparent layer) 133 is provided on the phosphor layer 30. A transparent layer (second transparent layer) 134 is provided on the transparent layer 133 and on the insulating member 127 in the off-chip region.

The transparent layer 134 is made of transparent glass or transparent resin. In the case of transparent glass, an adhesive layer made of transparent resin may be inserted. Alternatively, the transparent layer 134 may include a plurality of particles of a scattering material (such as silicon oxide titanium compound, and zinc oxide), and a binding material (e.g., transparent resin or transparent glass). The scattering material scatters emission light of the light emitting layer 13. The binding material is transmissive to emission light of the light emitting layer 13.

In the latter case, the transparent layer 134 functions as a light scattering layer. The planar size of the transparent layer 134 functioning as a light scattering layer is larger than the planar size of the phosphor layer 30 and the planar size of the transparent layer 133. That is, the planar size of the transparent layer 134 is larger than the planar size of the light emitting element 5. This can expand the range of light emitted outside from the semiconductor light emitting device 102 and enables wide-angle light distribution characteristics.

The surface of at least the portion of the insulating member 127 close to the side surface of the semiconductor layer 15 is reflective to emission light of the light emitting layer 13. The portion of the insulating member 127 close to the side surface of the phosphor layer 30 and close to the side surface of the transparent layer 133 is reflective to emission light of the light emitting layer 13 and emission light of the phosphor particles 31. Furthermore, the insulating member 127 near the boundary with the transparent layer 134 is reflective to emission light of the light emitting layer 13 and emission light of the phosphor particles 31.

For instance, the insulating member 127 is a resin layer having a reflectance of 50% or more to emission light of the light emitting layer 13 and emission light of the phosphor particles 31.

Thus, emission light from the side surface of the light emitting element 5 and light scattered by the transparent layer 134 and directed to the insulating member 127 side can be reflected by the insulating member 127. This can prevent absorption loss of light in the insulating member 127 to enhance the efficiency of light extraction to the outside through the transparent layer 134.

The phosphor layer 30 is not formed on the side surface of the semiconductor layer 15 and on the mounting surface side. That is, the phosphor layer 30 is not formed uselessly on the chip side surface side and the mounting surface side from which light is not extracted outside. This can reduce the cost.

The resin layer 125 different from the phosphor layer 30 is provided around the p-side external connection electrode 123 and around the n-side external connection electrode 124. This can provide the mounting surface side with characteristics suitable for stress relaxation. Furthermore, the resin layer 125 already provided on the mounting surface side dispenses with underfilling after mounting the semiconductor light emitting device 102 on the mounting substrate.

The phosphor layer 30 designed preferentially for light extraction efficiency, color conversion efficiency, and light distribution characteristics is provided on the first surface 15a side of the semiconductor layer 15. Layers designed preferentially for stress relaxation at the time of mounting and characteristics for a support body replacing the substrate are provided on the mounting surface side. For instance, the resin layer 125 has a structure in which a base resin is filled with filler such as silica particles at high density. Thus, the hardness of the resin layer 125 is adjusted to a level suitable for a support body.

In the semiconductor light emitting device 102 of the second embodiment, the semiconductor layer 15, the electrodes 7, 8, the on-chip wiring layers 116, 117, and the phosphor layer 30 are collectively formed in the wafer level. This realizes a chip-size light emitting element 5 at low cost. Furthermore, the external terminals (mounting surfaces) 123a, 124a can be extended to the off-chip region to improve heat dissipation capability. Thus, a semiconductor light emitting device 102 with high reliability can be provided at low cost.

FIG. 7 is a schematic sectional view of a semiconductor light emitting device 103 of a third embodiment.

The semiconductor light emitting device 103 includes a support substrate 10, a phosphor layer 30, and a semiconductor layer 15 provided between the support substrate 10 and the phosphor layer 30.

As described above, the semiconductor layer 15 includes a first layer 11, a second layer 12, and a light emitting layer 13 provided between the first layer 11 and the second layer 12. The first layer 11 has a first surface (asperity surface) 15a.

The support substrate 10 is provided on the opposite side of the semiconductor layer 15 from the first surface 15a via a metal layer (bonding metal) 63. A metal layer (back metal) 64 is provided on the surface of the support substrate 10 on the opposite side from the surface provided with the metal layer 63.

The phosphor layer 30 is provided on the first surface 15a side of the semiconductor layer 15. As described above, the phosphor layer 30 is an aggregate of a plurality of phosphor particles 31 and a plurality of inorganic particles 32.

A transparent inorganic film 19 is provided between the first surface 15a of the semiconductor layer 15 and the phosphor layer 30.

A p-side electrode 61 is provided between the semiconductor layer 15 and the metal layer 63. The p-side electrode 61 is in contact with the second layer 12. Part of the p-side electrode 61 extends outside from the side surface of the semiconductor layer 15. A p-side pad 62 is provided on the extending part. The second layer 12 is electrically connected to the p-side pad 62 through the p-side electrode 61.

An insulating film 65 is provided between the p-side electrode 61 and the metal layer 63. Thus, the p-side electrode 61 is insulated from the metal layer 63.

A plurality of n-side electrodes 63a are provided on the metal layer 63 integrally with the metal layer 63. The n-side electrode 63a penetrates through the p-side electrode 61, the second layer 12, and the light emitting layer 13 to the first layer 11. The n-side electrode 63a is electrically connected to the first layer 11. An insulating film 65 is provided between the n-side electrode 63a and the light emitting layer 13, between the n-side electrode 63a and the second layer 12, and between the n-side electrode 63a and the p-side electrode 61.

The semiconductor layer 15 is grown on the aforementioned monocrystalline substrate. After forming e.g. the p-side electrode 61 and the n-side electrodes 63a, the semiconductor layer 15 is laminated with the support substrate 10 via the metal layer 63. The support substrate 10 is conductive. The support substrate 10 is e.g. a silicon substrate. Thus, the first layer 11 is electrically connected to the metal layer (back surface electrode) 64 through the n-side electrode 63a, the metal layer 63, and the support substrate 10.

After the semiconductor layer 15 is laminated with the support substrate 10, the monocrystalline substrate is removed. Thus, the surface of the first layer 11 is exposed. After the first surface 15a of the first layer 11 is roughened, the transparent inorganic film 19 is formed. The phosphor layer 30 is formed on the transparent inorganic film 19.

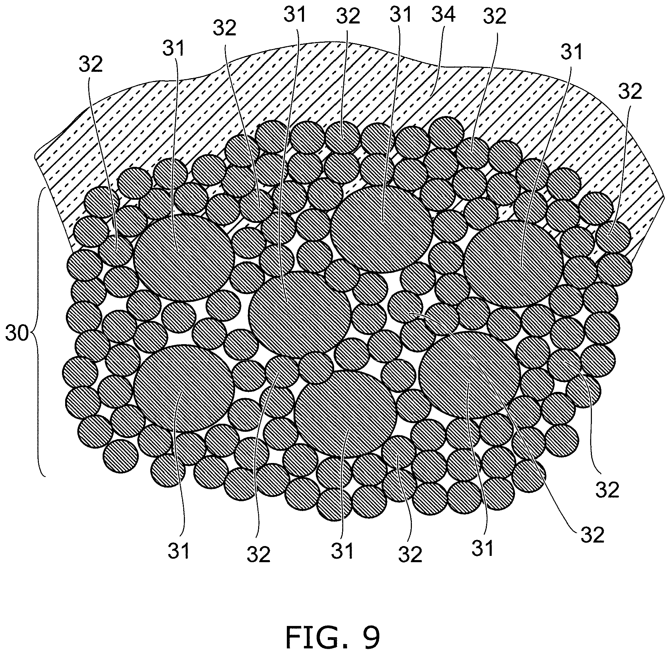

As shown in FIG. 9, a transparent inorganic film 34 covering the surface of the phosphor layer 30, i.e., the surface of the phosphor particles 31 and the surface of the inorganic particles 32, may be provided. As the transparent inorganic film 34, for instance, a silicon oxide film is formed by sputtering technique, CVD (chemical vapor deposition) technique, or coating technique. The transparent inorganic film 34 protects the surface of the phosphor layer 30 and reinforces the binding between the particles.

Depending on the method for forming the transparent inorganic film 34, the gap between the inorganic particles 32, and the gap between the inorganic particles 32 and the phosphor particles 31, inside the surface of the phosphor particles 31 and the surface of the inorganic particles 32 can be impregnated with part of the transparent inorganic film 34.

A silicon oxide film having low thermal conductivity may be formed as a transparent inorganic film 34. This can cause the transparent inorganic film 34 to function as a heat-insulating layer. For instance, the transparent inorganic film 34 may be formed between the phosphor layer 30 and the transparent resin layer 133 in the semiconductor light emitting device 102 shown in FIG. 4. This can suppress alteration and decomposition of the transparent resin layer 133 by heat of the phosphor particles 31.

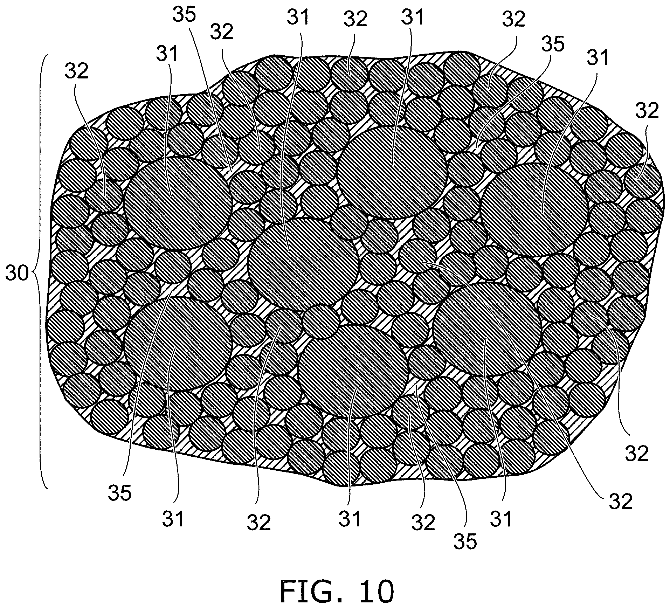

As shown in FIG. 10, a transparent resin 35 may be provided in the gap between the inorganic particles 32, and the gap between the inorganic particles 32 and the phosphor particles 31. The phosphor particles 31 and the inorganic particles 32 are not dispersed in the resin serving as a binder. In contrast, an aggregate of phosphor particles 31 and inorganic particles 32 is formed by the aforementioned method. Then, the gap between the particles is impregnated with the transparent resin 35.

A plurality of phosphor particles 31 are bound by a plurality of inorganic particles 32. The transparent resin 35 reinforces the binding between the phosphor particles 31 and the inorganic particles 32, and the binding between the inorganic particles 32. The structure including the transparent resin 35 between the particles suppresses reflection of light compared with the structure including voids between the particles.

## Claims

1. A semiconductor light emitting device comprising:
a light emitting element (4); and
a phosphor layer (30) provided on the light emitting element (4), and including a plurality of phosphor particles (31) and a plurality of inorganic particles (32) having smaller sizes than the phosphor particles (31), the phosphor particles (31) being bound together with aggregation of the inorganic particles (32) and the phosphor particles (31), wherein thermal conductivities of the inorganic particles (32) are 20 W/m·K or more.

2. The device according to claim 1, wherein the inorganic particles (32) primarily contain aluminum oxide, silicon nitride, or silicon carbide.

3. The device according to claim 1 or 2, wherein the phosphor layer (30) includes no resin, but includes voids (33) between the inorganic particles (32), and between the inorganic particles (32) and the phosphor particles (31).

4. The device according to any of claims 1-3, further comprising a first inorganic film (34) covering surfaces of the phosphor particles (31) and surfaces of the inorganic particles (32).

5. The device according to claim 4, wherein a part of the first inorganic film (34) is provided in gaps between the inorganic particles (32), and gaps between the inorganic particles (32) and the phosphor particles (31), inside the surfaces of the phosphor particles (31) and the surfaces of the inorganic particles (32).

6. The device according to claim 4 or 5, wherein the first inorganic film (34) is a silicon oxide film.

7. The device according to claim 1 or 2, further comprising a resin (35) provided in gaps between the inorganic particles (32), and gaps between the inorganic particles (32) and the phosphor particles (31).

8. The device according to any of claims 1-7, further comprising a second inorganic film (19) provided between the light emitting element (4) and the phosphor layer (30).

9. The device according to any of claims 1-8, wherein no resin film is provided between the light emitting element (4) and the phosphor layer (30).

10. The device according to any of claims 1-9, wherein no substrate is provided between the light emitting element (4) and the phosphor layer (30).

11. The device according to any of claims 1-10, wherein a grain boundary exists between the inorganic particles (32).

12. The device according to any of claims 1-11, wherein Young's modulus of the inorganic particles (32) is higher than Young's modulus of resin.

13. The device according to any of claims 1-12, wherein
the light emitting element (4) includes a semiconductor layer (15) and a resin layer (25) supporting the semiconductor layer (15), and
a side surface of the phosphor layer (30) is aligned with a side surface of the resin layer (25).

14. A method for forming a phosphor layer, comprising:
spraying a plurality of phosphor particles (31) and a plurality of inorganic particles (32) simultaneously or separately with a carrier gas onto a wafer including a light emitting element (4) to form an aggregate of the phosphor particles (31) and the inorganic particles (32) on the wafer, the inorganic particles (32) having smaller sizes than the phosphor particles (31), and thermal conductivities of the inorganic particles (32) being 20 W/m·K or more.

15. A method for forming a phosphor layer, comprising:
supplying a solution onto a wafer including a light emitting element (4), the solution containing a solvent, a plurality of phosphor particles (31) dispersed in the solvent, and a plurality of inorganic particles (32) dispersed in the solvent, the inorganic particles (32) having smaller sizes than the phosphor particle (31), and thermal conductivities of the inorganic particles (32) being 20 W/m·K or more; and
volatilizing the solvent to form an aggregate of the phosphor particles (31) and the inorganic particles (32) on the wafer.

16. The method according to claim 14 or 15, wherein
the light emitting element (4) is grown on a substrate, and then the substrate is removed to expose a first surface (15a) of the light emitting element (4), and
the aggregate is formed on the first surface (15a).

17. The method according to claim 14 or 15, further comprising impregnating the aggregate with resin (35).

## Patentansprüche

1. Lichtemittierende Halbleitervorrichtung, umfassend
ein lichtemittierendes Element (4); und
eine Phosphorschicht (30), die auf dem lichtemittierenden Element (4) vorgesehen ist und eine Vielzahl von Phosphorpartikeln (31) und eine Vielzahl von anorganischen Partikeln (32), die kleinere Größen als die Phosphorpartikel (31) aufweisen, enthält, wobei die Phosphorpartikel (31) durch Aggregation der anorganischen Partikel (32) und der Phosphorpartikel (31) miteinander verbunden sind, wobei die Wärmeleitfähigkeit der anorganischen Partikel (32) 20 W/m·K oder mehr beträgt.

2. Vorrichtung gemäß Anspruch 1, wobei die anorganischen Partikel (32) hauptsächlich Aluminiumoxid, Siliziumnitrid oder Siliziumkarbid enthalten.

3. Vorrichtung gemäß Anspruch 1 oder 2, wobei die Phosphorschicht (30) kein Harz aufweist, jedoch Hohlräume (33) zwischen den anorganischen Partikeln (32) und zwischen den anorganischen Partikeln (32) und den Phosphorpartikeln (31) aufweist.

4. Vorrichtung gemäß mindestens einem der Ansprüche 1-3, ferner umfassend einen ersten anorganischen Film (34), der die Oberflächen der Phosphorpartikel (31) und der Oberflächen der anorganischen Partikel (32) abdeckt.

5. Vorrichtung gemäß Anspruch 4, wobei ein Teil des ersten anorganischen Films (34) in Zwischenräumen zwischen den anorganischen Partikeln (32) und in Zwischenräumen zwischen den anorganischen Partikeln (32) und den Phosphorpartikeln (31) innerhalb der Oberflächen der Phosphorpartikel (31) und der Oberflächen der anorganischen Partikel (32) vorgesehen ist.

6. Vorrichtung gemäß Anspruch 4 oder 5, wobei der erste anorganische Film (34) ein Siliziumoxidfilm ist.

7. Vorrichtung gemäß Anspruch 1 oder 2, ferner umfassend ein Harz (35), das in Zwischenräumen zwischen den anorganischen Partikeln (32) und in Zwischenräumen zwischen den anorganischen Partikeln (32) und den Phosphorpartikeln (31) vorgesehen ist.

8. Vorrichtung gemäß mindestens einem der Ansprüche 1-7, ferner umfassend einen zweiten anorganischen Film (19), der zwischen dem lichtemittierenden Element (4) und der Phosphorschicht (30) vorgesehen ist.

9. Vorrichtung gemäß mindestens einem der Ansprüche 1-8, wobei zwischen dem lichtemittierenden Element (4) und der Phosphorschicht (30) kein Harzfilm vorgesehen ist.

10. Vorrichtung gemäß mindestens einem der Ansprüche 1-9, wobei zwischen dem lichtemittierenden Element (4) und der Phosphorschicht (30) kein Substrat vorgesehen ist.

11. Vorrichtung gemäß mindestens einem der Ansprüche 1-10, wobei zwischen den anorganischen Partikeln (32) eine Korngrenze besteht.

12. Vorrichtung gemäß mindestens einem der Ansprüche 1-11, wobei ein Elastizitätsmodul (Young's modulus) der anorganischen Partikel (32) höher ist als ein Elastizitätsmodul des Harzes.

13. Vorrichtung gemäß mindesten einem der Ansprüche 1-12, wobei
das lichtemittierende Element (4) eine Halbleiterschicht (15) und eine Harzschicht (25), die die Halbleiterschicht (15) trägt, umfasst, und
eine Seitenfläche der Phosphorschicht (30) an einer Seitenfläche der Harzschicht (25) ausgerichtet ist.

14. Verfahren zur Bildung einer Phosphorschicht, umfassend
das gleichzeitige oder getrennte Aufsprühen einer Vielzahl von Phosphorpartikeln (31) und einer Vielzahl von anorganischen Partikeln (32) mit einem Trägergas auf einen Wafer, der ein lichtemittierendes Element (4) enthält, zur Bildung eines Aggregats aus den Phosphorpartikeln (31) und den anorganischen Partikeln (32) auf dem Wafer, wobei die anorganischen Partikel (32) kleinere Größen als die Phosphorpartikel (31) aufweisen, und wobei die Wärmeleitfähigkeit der anorganischen Partikel (32) 20 W/m·K oder mehr beträgt.

15. Verfahren zur Bildung einer Phosphorschicht, umfassend
das Zuführen einer Lösung auf einen Wafer, der ein lichtemittierendes Element (4) enthält, wobei die Lösung ein Lösungsmittel, eine Vielzahl von in dem Lösungsmittel dispergierten Phosphorpartikeln (31) und eine Vielzahl von in dem Lösungsmittel dispergierten anorganischen Partikeln (32) enthält, wobei die anorganischen Partikel (32) kleinere Größen als die Phosphorpartikel (31) aufweisen, und die Wärmeleitfähigkeit der anorganischen Partikel (32) 20 W/m·K oder mehr beträgt; und
Verdampfung des Lösungsmittels zur Bildung eines Aggregats aus den Phosphorpartikeln (31) und den anorganischen Partikeln (32) auf dem Wafer.

16. Verfahren gemäß Anspruch 14 oder 15, wobei
das lichtemittierende Element (4) auf einem Substrat gezüchtet wird, und das Substrat anschließend entfernt wird, um eine erste Oberfläche (15a) des lichtemittierenden Elements (4) freizulegen, und
wobei das Aggregat auf der ersten Oberfläche (15a) gebildet wird.

17. Verfahren gemäß Anspruch 14 oder 15, ferner umfassend die Imprägnierung des Aggregats mit Harz (35).

## Revendications

1. Dispositif électroluminescent à semi-conducteur comprenant :
un élément électroluminescent (4) ; et
une couche de luminophore (30) disposée sur l'élément électroluminescent (4) et incluant une pluralité de particules luminophores (31) et une pluralité de particules inorganiques (32) ayant des tailles plus petites que celles des particules luminophores (31), les particules luminophores (31) étant reliées ensemble avec une agrégation des particules inorganiques (32) et des particules luminophores (31), dans lequel les conductivités thermiques des particules inorganiques (32) sont égales ou supérieures à 20 W/m·K.

2. Dispositif selon la revendication 1, dans lequel les particules inorganiques (32) contiennent principalement de l'oxyde d'aluminium, du nitrure de silicium ou du carbure de silicium.

3. Dispositif selon la revendication 1 ou 2, dans lequel la couche de luminophore (30) n'inclut pas de résine mais inclut des vides (33) entre les particules inorganiques (32) et entre les particules inorganiques (32) et les particules luminophores (31).

4. Dispositif selon l'une quelconque des revendications 1 à 3, comprenant en outre un premier film inorganique (34) recouvrant des surfaces des particules luminophores (31) et des surfaces des particules inorganiques (32).

5. Dispositif selon la revendication 4, dans lequel une partie du premier film inorganique (34) est disposée dans des espaces entre les particules inorganiques (32) et dans des espaces entre les particules inorganiques (32) et les particules luminophores (31), à l'intérieur des surfaces des particules luminophores (31) et des surfaces des particules inorganiques (32).

6. Dispositif selon la revendication 4 ou 5, dans lequel le premier film inorganique (34) est un film en oxyde de silicium.

7. Dispositif selon la revendication 1 ou 2, comprenant en outre une résine (35) disposée dans des espaces entre les particules inorganiques (32), et dans des espaces entre les particules inorganiques (32) et les particules luminophores (31).

8. Dispositif selon l'une quelconque des revendications 1 à 7, comprenant en outre un second film inorganique (19) disposé entre l'élément électroluminescent (4) et la couche de luminophore (30).

9. Dispositif selon l'une quelconque des revendications 1 à 8, dans lequel aucun film de résine n'est disposé entre l'élément électroluminescent (4) et la couche de luminophore (30).

10. Dispositif selon l'une quelconque des revendications 1 à 9, dans lequel aucun substrat n'est disposé entre l'élément électroluminescent (4) et la couche de luminophore (30).

11. Dispositif selon l'une quelconque des revendications 1 à 10, dans lequel un joint de grains existe entre les particules inorganiques (32).

12. Dispositif selon l'une quelconque des revendications 1 à 11, dans lequel le module d'élasticité de Young des particules inorganiques (32) est plus important que le module d'élasticité de Young d'une résine.

13. Dispositif selon l'une quelconque des revendications 1 à 12, dans lequel
l'élément électroluminescent (4) inclut une couche semi-conductrice (15) et une couche de résine (25) supportant la couche semi-conductrice (15) et
une surface latérale de la couche luminophore (30) est alignée sur une surface latérale de la couche de résine (25).

14. Procédé pour former une couche de luminophore comprenant :
la pulvérisation d'une pluralité de couches luminophores (31) et d'une pluralité de particules inorganiques (32) en même temps ou séparément avec un gaz porteur sur une tranche incluant un élément électroluminescent (4) pour former un agrégat de particules luminophores (31) et de particules inorganiques (32) sur la tranche, les particules inorganiques (32) ayant des tailles plus petites que celles des particules luminophores (31) et les conductivités thermiques des particules inorganiques (32) étant égales ou supérieures à 20 W/m·K.

15. Procédé pour former une couche de luminophore comprenant :
la fourniture d'une solution sur une tranche incluant un élément électroluminescent (4), la solution contenant un solvant, une pluralité de particules luminophores (31) dispersées dans le solvant et une pluralité de particules inorganiques (32) dispersées dans le solvant, les particules inorganiques (32) ayant des tailles plus petites que celles des particules luminophores (31) et les conductivités thermiques des particules inorganiques (32) étant égales ou supérieures à 20 W/m-K ; et
la volatilisation du solvant pour former un agrégat des particules luminophores (31) et des particules inorganiques (32) sur la tranche.

16. Procédé selon la revendication 14 ou 15, dans lequel
l'élément électroluminescent (4) est amené à croître sur un substrat et, ensuite, le substrat est enlevé pour exposer une première surface (15a) de l'élément électroluminescent (4) et
l'agrégat est formé sur la première surface (15a).

17. Procédé selon la revendication 14 ou 15, comprenant en outre l'imprégnation de l'agrégat avec une résine (35).
